(19) Europäisches Patentamt
European Patent Office
Office européen des brevets

(11) **EP 4 657 100 A1**

(12) **EUROPEAN PATENT APPLICATION**
published in accordance with Art. 153(4) EPC

(43) Date of publication:
03.12.2025 Bulletin 2025/49

(21) Application number: 24764215.0

(22) Date of filing: 29.02.2024

(51) International Patent Classification (IPC):
*G01R 31/396* (2019.01)    *G01R 31/385* (2019.01)
*G01R 19/00* (2006.01)    *G01R 19/10* (2006.01)
*G01R 19/165* (2006.01)

(52) Cooperative Patent Classification (CPC):
G01R 19/00; G01R 19/10; G01R 19/165;
G01R 31/385; G01R 31/396; Y02E 60/10

(86) International application number:
PCT/KR2024/002644

(87) International publication number:
WO 2024/181816 (06.09.2024 Gazette 2024/36)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.03.2023 KR 20230028077

(71) Applicant: LG Energy Solution, Ltd.
Seoul 07335 (KR)

(72) Inventors:
• KIM, Ji Su
Daejeon 34122 (KR)
• LEE, Sun Jong
Daejeon 34122 (KR)
• SUNG, Yong Chul
Daejeon 34122 (KR)

(74) Representative: Plasseraud IP
104 Rue de Richelieu
CS92104
75080 Paris Cedex 02 (FR)

(54) **BATTERY MANAGEMENT APPARATUS AND OPERATING METHOD THEREOF**

(57)    A battery management apparatus, according to an embodiment disclosed in the present document, may comprise: a data management unit that calculates a plurality of average voltages of a plurality of batteries by using voltages of the plurality of batteries, which are measured over a certain period of time, respectively; and a controller that calculates a plurality of voltage deviations, which are deviations between the plurality of average voltages of the plurality of batteries, and diagnoses at least one battery from among the plurality of batteries by using cosine similarity between an average value of the plurality of voltage deviations of the plurality of batteries and the plurality of voltage deviations of the plurality of batteries.

200

| DATA MANAGEMENT UNIT 210 | CONTROLLER 220 | MEMORY 230 |

FIG.2

**Description**

**[TECHNICAL FIELD]**

CROSS-REFERENCE TO RELATED APPLICATION

This application claims priority to and the benefit of Korean Patent Application No. 10-2023-0028077 filed in the Korean Intellectual Property Office on March 2, 2023, the entire content of which is incorporated herein by reference.

TECHNICAL FIELD

Embodiments disclosed herein relate to a battery management apparatus and an operating method thereof.

**[BACKGROUND ART]**

An electric vehicle is supplied with electricity from outside to charge a battery cell, and then a motor is driven by a voltage charged in the battery cell to obtain power. In lithium battery cells using lithium ions for oxidation-reduction reaction, among various battery cells, lithium may precipitate on an electrode of the battery cell depending on use environments of charge and discharge, causing venting. When venting occurs in the battery cell, direct problems may occur in the battery cell, such as deterioration of battery cell performance, the increasing possibility of ignition due to leakage of an electrolyte, etc. Thus, a technique for determining whether venting occurs in the battery cell is required.

A conventional battery management apparatus may diagnose voltage abnormality of a battery cell due to occurrence of venting by comparing a long-term or short-term moving average voltage of an individual battery cell with an average voltage of battery cells, but this method may not adjust a threshold that is a criterion for diagnosing an abnormal battery cell below a certain level due to its vulnerability to noise, and may not detect an abnormal voltage of a battery cell due to micro-disconnection occurring in an electric vehicle.

**[DISCLOSURE]**

**[TECHNICAL PROBLEM]**

Embodiments disclosed herein aim to provide a battery management apparatus and an operating method thereof in which an abnormal battery cell may be early diagnosed by using a deviation between average voltages of battery cells.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery management apparatus according to an embodiment disclosed herein includes a data management unit configured to calculate a plurality of average voltages of each of a plurality of batteries by using a voltage of each of the plurality of batteries, measured for a specific period, and a controller configured to calculate a plurality of voltage deviations which are deviations between the plurality of average voltages of each of the plurality of batteries and diagnose at least one battery among the plurality of batteries by using a cosine similarity between an average of the plurality of voltage deviations of each of the plurality of batteries and the plurality of voltage deviations of each of the plurality of batteries.

According to an embodiment, the battery management apparatus may further include a memory configured to store the voltage of each of the plurality of batteries and an average voltage of each of the plurality of batteries.

According to an embodiment, the memory may be further configured to store an average voltage of each of the plurality of batteries in a circular queue at specific period.

According to an embodiment, the controller may be further configured to classify the plurality of voltage deviations of each of the plurality of batteries based on a calculation point in time and generate a first average which is an average of voltage deviations of each of the plurality of batteries, calculated at the same point in time.

According to an embodiment, the controller may be further configured to calculate a cosine similarity of each of the plurality of batteries, which is a cosine similarity between the first average and the plurality of voltage deviations of each of the plurality of batteries and calculate a first value which is a difference between a second average, which is an average of the cosine similarity of each of the plurality of batteries, and the cosine similarity of each of the plurality of batteries.

According to an embodiment, the controller may be further configured to increase a diagnosis count value of at least one of the plurality of batteries when a first value of the at least one battery is greater than or equal to a threshold.

According to an embodiment, the controller may be further configured to perform a diagnosis on at least one of the plurality of batteries when the diagnosis count value of the at least one battery is greater than or equal to a threshold count value.

An operating method of a battery management apparatus according to an embodiment disclosed herein includes calculating a plurality of average voltages of each of a plurality of batteries by using a voltage of each of the plurality of batteries, measured for a specific period, calculating a plurality of voltage deviations which are deviations between the plurality of average voltages of each of the plurality of batteries, calculating an average of the plurality of voltage deviations of each of the plurality of batteries, and diagnosing at least one battery among the plurality of batteries by using a cosine similarity between the average of the plurality of voltage deviations of each of the plurality of batteries and the plurality of voltage deviations of each of the plurality of batteries.

According to an embodiment, the calculating of the plurality of average voltages of each of the plurality of batteries by using the voltage of each of the plurality of batteries, measured for the specific period, may include storing an average voltage of each of the plurality of batteries in a circular queue at specific period.

According to an embodiment, the calculating of the average of the plurality of voltage deviations of each of the plurality of batteries may include classifying the plurality of voltage deviations of each of the plurality of batteries based on a calculation point in time and generating a first average which is an average of voltage deviations of each of the plurality of batteries, calculated at the same point in time.

According to an embodiment, the diagnosing of the at least one battery among the plurality of batteries by using a cosine similarity between the average of the plurality of voltage deviations of each of the plurality of batteries and the plurality of voltage deviations of each of the plurality of batteries may include calculating a cosine similarity of each of the plurality of batteries, which is a cosine similarity between the first average and the plurality of voltage deviations of each of the plurality of batteries and calculating a first value which is a difference between a second average, which is an average of the cosine similarity of each of the plurality of batteries, and the cosine similarity of each of the plurality of batteries.

According to an embodiment, the diagnosing of the at least one battery among the plurality of batteries by using a cosine similarity between the average of the plurality of voltage deviations of each of the plurality of batteries and the plurality of voltage deviations of each of the plurality of batteries may include increasing a diagnosis count value of at least one of the plurality of batteries when a first value of the at least one battery is greater than or equal to a threshold.

According to an embodiment, the diagnosing of the at least one battery among the plurality of batteries by using a cosine similarity between the average of the plurality of voltage deviations of each of the plurality of batteries and the plurality of voltage deviations of each of the plurality of batteries may include performing a diagnosis on at least one of the plurality of batteries when the diagnosis count value of the at least one battery is greater than or equal to a threshold count value.

**[ADVANTAGEOUS EFFECTS]**

With the battery management apparatus and the operating method thereof according to an embodiment disclosed herein, an abnormal battery cell may be early diagnosed by using a deviation between average voltages of battery cells.

**[DESCRIPTION OF DRAWINGS]**

FIG. 1 illustrates a battery pack according to an embodiment disclosed herein.
FIG. 2 is a block diagram illustrating a configuration of a battery management apparatus, according to an embodiment disclosed herein.
FIG. 3 is a graph showing a change in voltage of a battery cell according to an embodiment disclosed herein.
FIG. 4A is a table showing average voltage data of a battery cell according to an embodiment disclosed herein.
FIG. 4B is a graph showing average voltage data of a battery cell according to an embodiment disclosed herein.
FIG. 5A is a table showing voltage deviation data of a battery cell according to an embodiment disclosed herein.
FIG. 5B is a graph showing voltage deviation data of a battery cell according to an embodiment disclosed herein.
FIG. 6A is a table showing cosine similarity data of a battery cell according to an embodiment disclosed herein.
FIG. 6B is a graph showing cosine similarity data of a battery cell according to an embodiment disclosed herein.
FIG. 7 is a graph showing a ratio of a first value of a battery cell to a threshold according to an embodiment disclosed herein.
FIG. 8 is a flowchart showing an operating method of a battery management apparatus, according to an embodiment disclosed herein.

FIG. 9 is a block diagram showing a hardware configuration of a computing system for performing an operating method of a battery management apparatus, according to an embodiment disclosed herein.

**[MODE FOR INVENTION]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

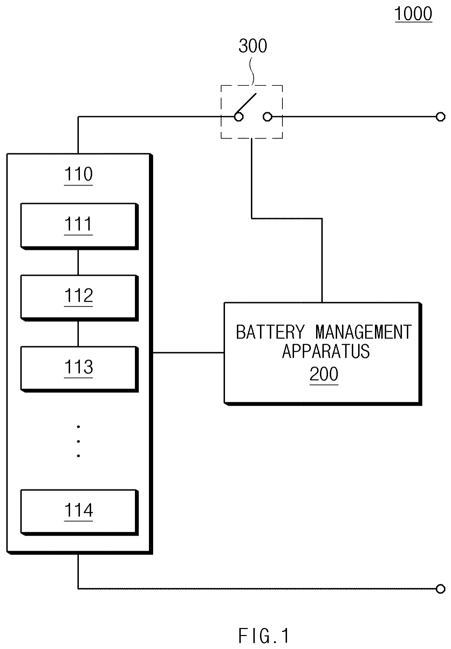

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SoC), a state of health (SoH) etc., based on a measurement value such as monitored voltage, current, temperature, etc.

The battery management apparatus 200 may diagnose an abnormal voltage of at least one battery cell among the plurality of battery cells 110, 120, 130, and 140, by using an accumulative voltage of each of the plurality of battery cells 110, 120, 130, and 140 and an average voltage calculated based on the accumulative voltage.

The battery management apparatus 200 may calculate plural average voltage data from accumulative voltage data of each of the plurality of battery cells 110, 120, 130, and 140. The battery management apparatus 200 may calculate a voltage deviation dV between plural average voltage data of each of the plurality of battery cells 110, 120, 130, and 140, and diagnose an abnormal voltage of at least one battery cell among the plurality of battery cells 110, 120, 130, and 140 by using a cosine similarity between the voltage deviation of each of the plurality of battery cells 110, 120, 130, and 140 and an average of the voltage deviations of the plurality of battery cells 110, 120, 130, and 140.

The battery management apparatus 200 may precisely diagnose a battery cell without reflecting a distorted trend of voltage data of the plurality of battery cells 110, 120, 130, and 140 by using the voltage deviations of the plurality of battery cells 110, 120, 130, and 140 instead of using a moving average voltage of the plurality of battery cells. The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

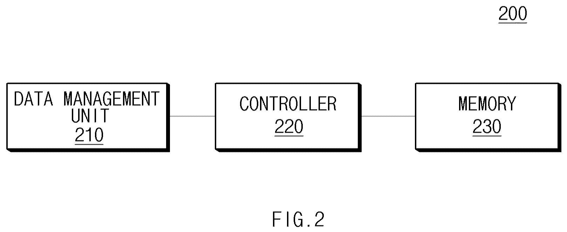

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a data management unit 210, a controller 220, and a memory 230.

The data management unit 210 may calculate a plurality of average voltages of each of the plurality of battery cells 110, 120, 130, and 140. First, the data management unit 210 may measure a voltage of each of the plurality of battery cells 110, 120, 130, and 140.

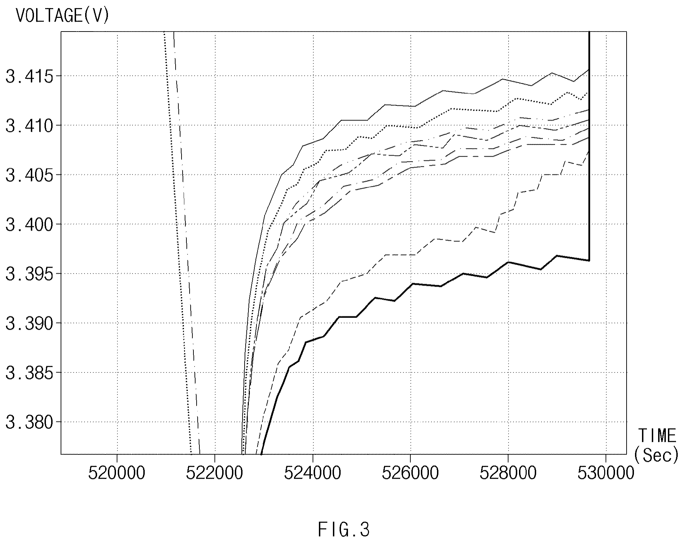

FIG. 3 is a graph showing a change in voltage of a battery cell according to an embodiment disclosed herein.

Referring to FIG. 3, the data management unit 210 may measure a voltage of each of the plurality of battery cells 110, 120, 130, and 140 for a preset specific period. The data management unit 210 may monitor a change in voltage of each of the plurality of battery cells 110, 120, 130, and 140 by measuring the voltage of each of the plurality of battery cells 110, 120, 130, and 140 for a specific period.

The data management unit 210 may store the voltage of each of the plurality of battery cells 110, 120, 130, and 140 in the memory 230. For example, the data management unit 210 may separately store the voltage of each of the plurality of battery cells 110, 120, 130, and 140 in the memory 230 or store the voltage separately for each battery module 100 including the plurality of battery cells 110, 120, 130, and 140.

The data management unit 210 may accumulate the voltage of each of the plurality of battery cells 110, 120, 130, and 140 measured for the specific period. For example, the data management unit 210 may accumulate the voltage of each of the plurality of battery cells 110, 120, 130, and 140 measured 200 times for the specific period. For example, the data management unit 210 may measure the voltage of the first battery cell 110 and accumulate the voltage of the first battery cell 110 measured 200 times for the specific period. The data management unit 210 may repeat operations of measuring the voltage of the battery cell and accumulating the voltage of each battery cell measured for the specific period, as many times as the number of battery cells included in the battery module 100.

The data management unit 210 may accumulatively store the voltage of each of the plurality of battery cells 110, 120, 130, and 140 in the memory 230. That is, the data management unit 210 may calculate an accumulative voltage of each of the plurality of battery cells 110, 120, 130, and 140.

The data management unit 210 may calculate an average voltage of each of the plurality of battery cells 110, 120, 130, and 140 by dividing the accumulative voltage of each of the plurality of battery cells 110, 120, 130, and 140 measured and accumulated for the specific period by the number of measurement operations. For example, the controller 220 may calculate an average voltage of the first battery cell 110 by dividing the voltage of the first battery cell 110 measured 200 times and accumulated for the specific period by 200.

The data management unit 210 may calculate a plurality of average voltages of each of the plurality of battery cells 110, 120, 130, and 140 and store the same in the memory 230. More specifically, the data management unit 210 may repeatedly calculate an average voltage of each of the plurality of battery cells 110, 120, 130, and 140 at specific period. For example, when the current time is set to 'T', the data management unit 210 may repeatedly calculate an average voltage of the plurality of battery cells 110, 120, 130, and 140 at the past time 'T-4', a time 'T-3', a time 'T-2', a time 'T-1', and the current time 'T' and store the same in the memory 230.

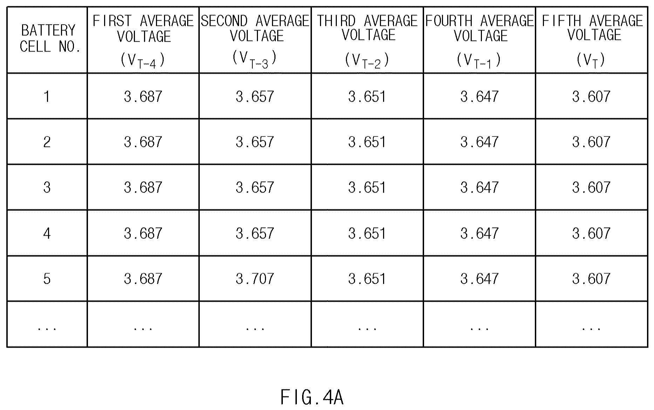

FIG. 4A is a table showing average voltage data of a battery cell according to an embodiment disclosed herein.

Referring to FIG. 4A, when the current time is set to 'T', the data management unit 210 may calculate a first average voltage $V_{T-4}$ that is an average voltage of each of the plurality of battery cells 110, 120, 130, and 140, calculated at the time 'T-4', a second average voltage $V_{T-3}$ that is an average voltage of each of the plurality of battery cells 110, 120, 130, and 140, calculated at the time 'T-3', a third average voltage $V_{T-2}$ that is an average voltage of each of the plurality of battery cells 110, 120, 130, and 140, calculated at the time 'T-2', a fourth average voltage $V_{T-1}$ that is an average voltage of each of the plurality of battery cells 110, 120, 130, and 140, calculated at the time 'T-1', and a fifth average voltage $V_T$ that is an average voltage of each of the plurality of battery cells 110, 120, 130, and 140, calculated at the time 'T'.

The data management unit 210 may store the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 in chronological order.

The memory 230 may accumulatively store the voltage of each of the plurality of battery cells 110, 120, 130, and 140 measured by the data management unit 210 for each battery cell. The memory 230 may separately store the voltage of each of the plurality of battery cells 110, 120, 130, and 140 or store the voltage separately for each battery module 100 including the plurality of battery cells 110, 120, 130, and 140.

The memory 230 may include a plurality of buffers that temporarily accumulate the voltage of each of the plurality of battery cells 110, 120, 130, and 140 for each battery cell. The buffer has a limited size of data that may be stored, and thus may temporarily store data. For example, the memory 230 may include a plurality of buffers that temporarily accumulate a voltage of any one of the plurality of battery cells 110, 120, 130, and 140. Herein, each of the plurality of buffers may be set to have a window size capable of accumulating a voltage of a corresponding battery cell as many times as a preset number of times. For example, each buffer may be set to have a window size capable of accumulating a voltage of a battery cell, measured 200 times.

The memory 230 may include a plurality of circular queues capable of temporarily storing a plurality of average voltages of each of the plurality of battery cells 110, 120, 130, and 140. Herein, the queue may be defined as a data structure in which a continuous space is allocated such that first input data is output first. According to an embodiment, each of the plurality of circular queues may include a plurality of buffers. For example, the memory 230 may temporarily store the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 continuously, by using the plurality of circular queues including five buffers.

The memory 230 may temporarily store the plurality of average voltages of each of the plurality of battery cells 110, 120, 130, and 140 at specific period. For example, the memory 230 may update the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 at specific period, by using the plurality of circular queues including five buffers.

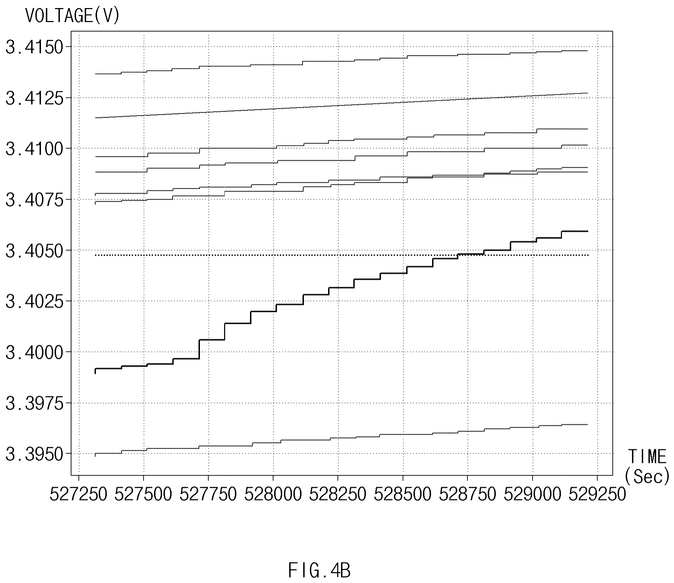

FIG. 4B is a graph showing average voltage data of a battery cell according to an embodiment disclosed herein.

Referring to FIG. 4B, the data management unit 210 may repeatedly calculate an average voltage of each of the plurality of battery cells 110, 120, 130, and 140 by using the accumulative voltage of each of the plurality of battery cells 110, 120, 130, and 140, measured for a specific period.

The controller 220 may calculate a plurality of average voltages of each of the plurality of battery cells 110, 120, 130, and 140.

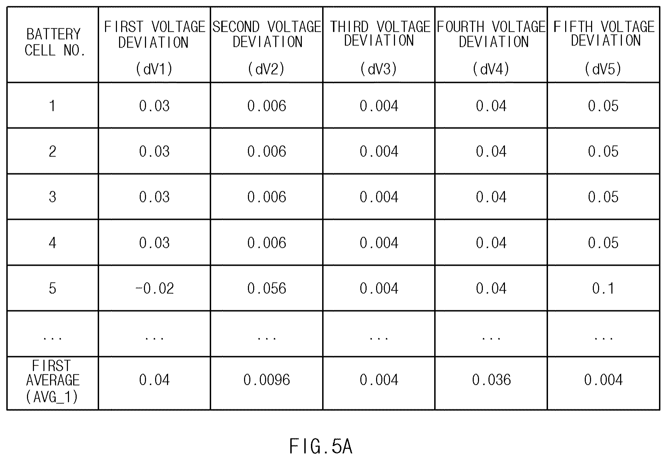

FIG. 5A is a table showing voltage deviation data of a battery cell according to an embodiment disclosed herein.

Referring to FIG. 5A, for example, the controller 220 may calculate a first voltage deviation dV1 that is a deviation between the first average voltage $V_{T-4}$, which is an average voltage calculated at the time 'T-4', and the second average voltage $V_{T-3}$, which is an average voltage calculated at the time 'T-3', of each of the plurality of battery cells 110, 120, 130, and 140.

The controller 220 may calculate a second voltage deviation dV2 that is a deviation between the second average voltage $V_{T-3}$, which is an average voltage calculated at the time 'T-3', and the third average voltage $V_{T-2}$, which is an average voltage calculated at the time 'T-2', of each of the plurality of battery cells 110, 120, 130, and 140.

The controller 220 may calculate a third voltage deviation dV3 that is a deviation between the third average voltage $V_{T-2}$, which is an average voltage calculated at the time 'T-2', and the fourth average voltage $V_{T-1}$, which is an average voltage calculated at the time 'T-1', of each of the plurality of battery cells 110, 120, 130, and 140.

The controller 220 may calculate a fourth voltage deviation dV4 that is a deviation between the fourth average voltage $V_{T-1}$, which is an average voltage calculated at the time 'T-1', and the fifth average voltage $V_T$, which is an average voltage calculated at the time 'T', of each of the plurality of battery cells 110, 120, 130, and 140.

That is, the controller 220 may calculate a deviation between consecutively calculated average voltages, i.e., a deviation between the first average voltage $V_{T-4}$ and the second average voltage $V_{T-3}$, a deviation between the second average voltage $V_{T-3}$ and the third average voltage $V_{T-2}$, a deviation between the third average voltage $V_{T-2}$ and the fourth average voltage $V_{T-1}$, and a deviation between the fourth average voltage $V_{T-1}$ and the fifth average voltage $V_T$, so as to analyze a short-term voltage behavior of each of the plurality of battery cells 110, 120, 130, and 140.

To analyze a long-term voltage behavior of each of the plurality of battery cells 110, 120, 130, and 140, the controller 220 may calculate a deviation between average voltages that are not calculated consecutively. For example, the controller 220 may calculate a fifth voltage deviation dV5 that is a deviation between the second average voltage $V_{T-3}$, which is the average voltage calculated at the time 'T-3', and the fifth average voltage $V_T$, which is the average voltage calculated at the time 'T', of each of the plurality of battery cells 110, 120, 130, and 140.

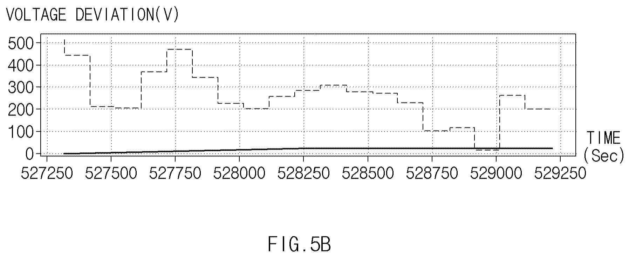

FIG. 5B is a graph showing voltage deviation data of a battery cell according to an embodiment disclosed herein.

Referring to FIG. 5B, the controller 220 may continuously calculate a voltage deviation of each of the plurality of battery cells 110, 120, 130, and 140 at specific period.

Referring back to FIG. 5A, the controller 220 may classify a plurality of voltage deviations of each of the plurality of battery cells 110, 120, 130, and 140 based on a calculation point in time. The controller 220 may generate a first average AVG_1 that is an average of voltage deviations of each of the plurality of battery cells 110, 120, 130, and 140 calculated at the same calculation point in time.

For example, the controller 220 may classify the voltage deviations of each of the plurality of battery cells 110, 120, 130, and 140 based on a calculation point in time and calculate the first average AVG_1 of the first voltage deviations dV1 calculated at the same point in time, the first average AVG_1 of the second voltage deviations dV2 calculated at the same point in time, the first average AVG_1 of the third voltage deviations dV3 calculated at the same point in time, the first average AVG_1 of the fourth voltage deviations dV4 calculated at the same point in time, and the first average AVG_1 of the fifth voltage deviations dV5 calculated at the same point in time, of each of the plurality of battery cells 110, 120, 130, and 140.

The controller 220 may calculate a cosine similarity between the plurality of first averages AVG_1 of the plurality of battery cells 110, 120, 130, and 140 and the plurality of voltage deviations of each of the plurality of battery cells 110, 120, 130, and 140. Herein, the cosine similarity may mean a similarity between two vectors, measured using a cosine value of an angle between the vectors. The cosine similarity may be used to determine a similarity in direction rather than vector magnitude. Thus, even when a change amount of a voltage of each of the plurality of battery cells 110, 120, 130, and 140 is different due to a large noise value in the battery module or a small capacity of the battery module 100, the controller 220 may determine an abnormal behavior of a voltage of at least one of the plurality of battery cells 110, 120, 130, and 140 by using the cosine similarity.

The controller 220 may calculate the cosine similarity between the plurality of first averages AVG_1 and the plurality of voltage deviations of each of the plurality of battery cells 110, 120, 130, and 140, based on Equation 1.

[Equation 1]

$$\text{Cosine Similarity} = \cos(\theta) = \frac{A \cdot B}{\|A\| \, \|B\|} = \frac{\Sigma_{i=1}^{n} A_i \times B_i}{\sqrt{\Sigma_{i=1}^{n}(A_i)^2} \times \sqrt{\Sigma_{i=1}^{n}(B_i)^2}}$$

The controller 220 may input the plurality of first averages AVG_1 of the plurality of battery cells 110, 120, 130, and 140 to 'A' of Equation 1 and input the plurality of voltage deviations of each of the plurality of battery cells 110, 120, 130, and 140 to 'B' of Equation 1, thus calculating the cosine similarity of each of the plurality of battery cells 110, 120, 130, and 140.

For example, the controller 220 may input, to 'A' of Equation 1, the plurality of first averages AVG_1 of the plurality of battery cells 110, 120, 130, and 140, i.e., the first average AVG_1 of the first voltage deviations dV1, the first average AVG_1 of the second voltage deviations dV2, the first average AVG_1 of the third voltage deviations dV3, the first average AVG_1 of the fourth voltage deviations dV4. and the first average AVG_1 of the fifth voltage deviations dV5, of each of the plurality of battery cells 110, 120, 130, and 140, which are [0.04, 0.0096, 0.004, 0.036, 0.004].

For example, the controller 220 may input, to 'B' of Equation 1, the plurality of voltage deviations of each of the plurality of battery cells 110, 120, 130, and 140, i.e., the first voltage deviation dV1, the second voltage deviation dV2, the third voltage deviation dV3, the fourth voltage deviation dV4, and the fifth voltage deviation dV5. For example, the controller 220 may input, to 'B' of Equation 1, the plurality of voltage deviations of the first battery cell 110, i.e., the first voltage deviation dV1, the second voltage deviation dV2, the third voltage deviation dV3, the fourth voltage deviation dV4, and the fifth voltage deviation dV5, which are [0.03, 0.006, 0.004, 0.04, 0.05].

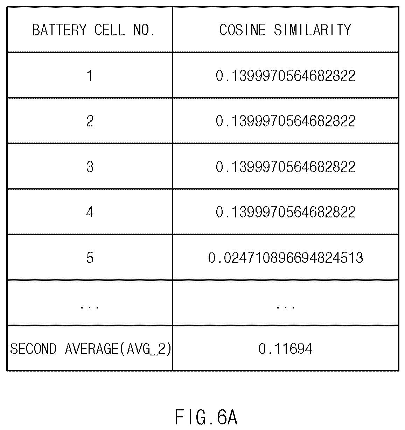

FIG. 6A is a table showing cosine similarity data of a battery cell according to an embodiment disclosed herein.

Referring to FIG. 6A, the controller 220 may calculate a cosine similarity of each of the plurality of battery cells 110, 120, 130, and 140 by using Equation 1.

According to an embodiment, the controller 220 may calculate the second average AVG_2 that is an average of cosine similarities of the plurality of battery cells 110, 120, 130, and 140.

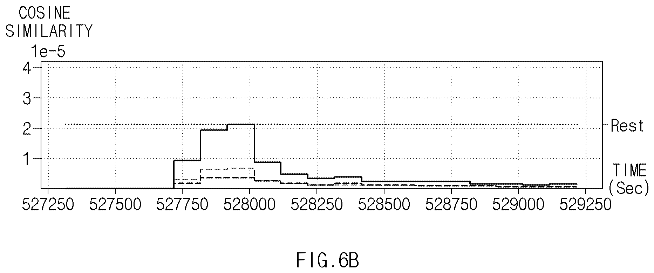

FIG. 6B is a graph showing cosine similarity data of a battery cell according to an embodiment disclosed herein.

Referring to FIG. 6B, the controller 220 may continuously calculate a cosine similarity of each of the plurality of battery cells 110, 120, 130, and 140 at specific period.

The controller 220 may diagnose at least one of the plurality of battery cells 110, 120, 130, and 140, by using the second average AVG_2 and the cosine similarity of each of the plurality of battery cells 110, 120, 130, and 140.

More specifically, the controller 220 may calculate a first value that is a difference between the second average AVG_2 that is an average of cosine similarities of the plurality of battery cells 110, 120, 130, and 140 and the cosine similarity of each of the plurality of battery cells 110, 120, 130, and 140.

The controller 220 may determine whether the first value of at least one of the plurality of battery cells 110, 120, 130, and 140 is greater than or equal to a threshold.

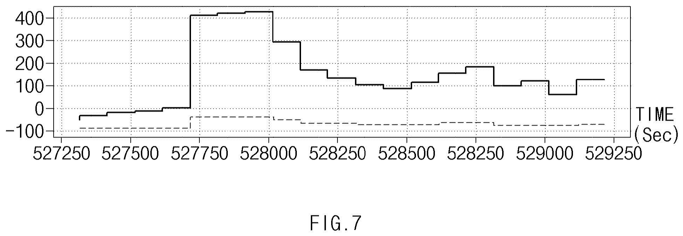

FIG. 7 is a graph showing a ratio of a first value of a battery cell to a threshold according to an embodiment disclosed herein.

Referring to FIG. 7, the controller 220 may continuously calculate a ratio of the first value of each of the plurality of battery cells 110, 120, 130, and 140 to the threshold at specific period. That is, the controller 220 may continuously calculate the rate of the first value of each of the plurality of battery cells 110, 120, 130, and 140 to the threshold at specific period to analyze an abnormal behavior of the voltage of each of the plurality of battery cells 110, 120, 130, and 140 with respect to the total voltage of the plurality of battery cells 110, 120, 130, and 140. That is, the controller 220 may continuously, at specific period, perform an analysis indicating how much the voltage of each of the plurality of battery cells 110, 120, 130, and 140 is different from a voltage of a normal battery cell.

When the first value of at least one of the plurality of battery cells 110, 120, 130, and 140 is greater than or equal to the threshold, the controller 220 may increase a diagnosis count value of the at least one battery cell.

When the diagnosis count value of at least one of the plurality of battery cells 110, 120, 130, and 140 is greater than or equal to a threshold count value, the controller 220 may determine the at least one battery cell as an abnormal battery cell and perform a diagnosis. For example, when the diagnosis count value of at least one of the plurality of battery cells 110, 120, 130, and 140 reaches a threshold count value of 100, the controller 220 may determine the at least one battery cell as an abnormal battery cell and perform a diagnosis.

When the controller 220 determines that the battery cell is abnormal, as a result of the diagnosis, the controller 220 may provide information about the abnormal battery cell to a user. For example, the controller 220 may provide information about an abnormal battery cell to a user terminal through a communication unit (not shown) and provide the information about the abnormal battery cell through a display provided in a vehicle, a charger, etc.

As described above, the battery management apparatus 200 according to an embodiment disclosed herein may early diagnose an abnormal battery cell by using a deviation between average voltages of battery cells.

With a conventional battery management apparatus, past values have a continuous influence based on weights due to use of a moving average voltage, but with the battery management apparatus 200 according to an embodiment disclosed herein, a trend of an undistorted voltage may be reflected using an arithmetic average equaling a window size of a memory, and a plurality of arithmetic averages may be used, thus removing a need for a separate noise cancellation process.

Moreover, the battery management apparatus 200 may compare a plurality of voltage deviations dV of each of the plurality of battery cells 110, 120, 130, and 140 and calculate a deviation between distant voltages as well as a deviation between adjacent voltages, thereby analyzing features of a short-term voltage behavior and a long-term voltage behavior of the battery cells.

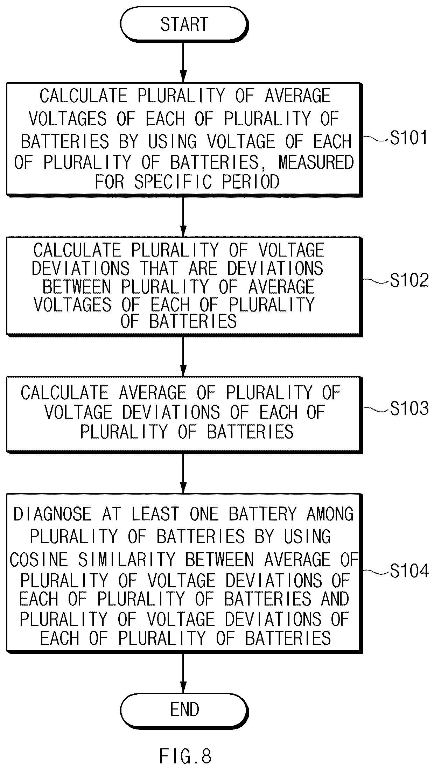

FIG. 8 is a flowchart showing an operating method of a battery management apparatus, according to an embodiment disclosed herein.

Hereinbelow, an operating method of the battery management apparatus 200 will be described with reference to FIGS. 1 to 7.

The battery management apparatus 200 may be substantially the same as the battery management apparatus 200 described with reference to FIGS. 1 to 7, and thus will be briefly described to avoid redundant description.

Referring to FIG. 8, an operating method of the battery management apparatus 200 may include operation S101 of calculating a plurality of average voltages of each of a plurality of batteries by using a voltage of each of the plurality of batteries, measured for a specific period, operation S102 of calculating a plurality of voltage deviations that are deviations between the plurality of average voltages of each of the plurality of batteries, operation S103 of calculating an average of the plurality of voltage deviations of each of the plurality of batteries, and operation S104 of diagnosing at least one of the plurality of batteries by using a cosine similarity between the average of the plurality of voltage deviations of each of the plurality of batteries and the plurality of voltage deviations of each of the plurality of batteries.

Hereinbelow, operations S101 through S104 will be described in detail.

In operation S101, the data management unit 210 may calculate the plurality of average voltages of each of the plurality of battery cells 110, 120, 130, and 140. First, the data management unit 210 may measure the voltage of each of the plurality of battery cells 110, 120, 130, and 140.

In operation S101, the data management unit 210 may measure the voltage of each of the plurality of battery cells 110, 120, 130, and 140 for a preset specific period. The data management unit 210 may monitor a change in voltage of each of the plurality of battery cells 110, 120, 130, and 140 by measuring the voltage of each of the plurality of battery cells 110, 120, 130, and 140 for the specific period.

In operation S101, the data management unit 210 may store the voltage of each of the plurality of battery cells 110, 120, 130, and 140 in the memory 230. In operation S101, for example, the data management unit 210 may separately store the voltage of each of the plurality of battery cells 110, 120, 130, and 140 in the memory 230 or store the voltage separately for each battery module 100 including the plurality of battery cells 110, 120, 130, and 140.

In operation S101, the data management unit 210 may accumulate the voltage of each of the plurality of battery cells 110, 120, 130, and 140 measured for the specific period. In operation S101, for example, the data management unit 210 may accumulate the voltage of each of the plurality of battery cells 110, 120, 130, and 140 measured 200 times for the specific period. In operation S101, for example, the data management unit 210 may measure the voltage of the first battery cell 110 and accumulate the voltage of the first battery cell 110 measured 200 times for the specific period. In operation S101, the data management unit 210 may repeat operations of measuring the voltage of the battery cell and accumulating the voltage of each battery cell measured for the specific period, as many times as the number of battery cells included in the battery module 100.

In operation S101, the data management unit 210 may accumulatively store the voltage of each of the plurality of battery cells 110, 120, 130, and 140 in the memory 230. That is, the data management unit 210 may calculate an accumulative voltage of each of the plurality of battery cells 110, 120, 130, and 140.

In operation S101, the data management unit 210 may calculate an average voltage of each of the plurality of battery cells 110, 120, 130, and 140 by dividing the accumulative voltage of each of the plurality of battery cells 110, 120, 130, and 140 measured and accumulated for the specific period by the number of measurement operations.

In operation S101, the data management unit 210 may calculate a plurality of average voltages of each of the plurality of battery cells 110, 120, 130, and 140 and store the same in the memory 230. In operation S101, for example, the data management unit 210 may repeatedly calculate the average voltage of each of the plurality of battery cells 110, 120, 130, and 140 at specific period. In operation S101, for example, when the current time is set to 'T', the data management unit 210 may repeatedly calculate an average voltage of the plurality of battery cells 110, 120, 130, and 140 at the past time 'T-4', a time 'T-3', a time 'T-2', a time 'T-1', and the current time 'T' and store the same in the memory 230.

In operation S101, for example, when the current time is set to 'T', the data management unit 210 may calculate the first average voltage $V_{T-4}$ that is an average voltage of each of the plurality of battery cells 110, 120, 130, and 140 calculated at the time 'T-4', the second average voltage $V_{T-3}$ that is an average voltage calculated at the time 'T-3', the third average voltage $V_{T-2}$ that is an average voltage calculated at the time 'T-2', the fourth average voltage $V_{T-1}$ that is an average voltage calculated at the time 'T-1', and the fifth average voltage $V_T$ that is an average voltage calculated at the time 'T'.

In operation S101, the data management unit 210 may store the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 in chronological order.

In operation S101, the memory 230 may accumulatively store the voltage of each of the plurality of battery cells 110, 120, 130, and 140 measured by the data management unit 210 for each battery cell. The memory 230 may separately store the voltage of each of the plurality of battery cells 110, 120, 130, and 140 or store the voltage separately for each battery module 100 including the plurality of battery cells 110, 120, 130, and 140.

In operation S101, the memory 230 may include a plurality of buffers that temporarily accumulate the voltage of each of the plurality of battery cells 110, 120, 130, and 140 for each battery cell. For example, the memory 230 may include a plurality of buffers that temporarily accumulate a voltage of any one of the plurality of battery cells 110, 120, 130, and 140. Herein, each of the plurality of buffers may be set to have a window size capable of accumulating a voltage of a corresponding battery cell as many times as a preset number of times. For example, each buffer may be set to have a window size capable of accumulating a voltage of a battery cell, measured 200 times.

In operation S101, the memory 230 may include a plurality of circular queues capable of temporarily storing a plurality of average voltages of each of the plurality of battery cells 110, 120, 130, and 140. Herein, the queue may be defined as a data structure in which a continuous space is allocated such that first input data is output first. According to an embodiment, each of the plurality of circular queues may include a plurality of buffers.

In operation S101, for example, the memory 230 may temporarily store the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 continuously, by using the plurality of circular queues including five buffers.

In operation S101, the memory 230 may temporarily store the plurality of average voltages of each of the plurality of battery cells 110, 120, 130, and 140 at specific period. In operation S101, for example, the memory 230 may update the first average voltage $V_{T-4}$, the second average voltage $V_{T-3}$, the third average voltage $V_{T-2}$, the fourth average voltage $V_{T-1}$, and the fifth average voltage $V_T$ of each of the plurality of battery cells 110, 120, 130, and 140 in the memory 230 at specific period, by using circular queues including five buffers.

In operation S101, the data management unit 210 may repeatedly calculate an average voltage of each of the plurality of battery cells 110, 120, 130, and 140 by using the accumulative voltage of each of the plurality of battery cells 110, 120, 130, and 140, measured for a specific period.

In operation S102, the controller 220 may calculate a plurality of voltage deviations that are deviations between the plurality of average voltages of each of the plurality of battery cells 110, 120, 130, and 140.

In operation S102, for example, the controller 220 may calculate the first voltage deviation dV1 that is a deviation between the first average voltage $V_{T-4}$, which is an average voltage calculated at the time 'T-4', and the second average voltage $V_{T-3}$, which is an average voltage calculated at the time 'T-3', of each of the plurality of battery cells 110, 120, 130, and 140.

In operation S102, the controller 220 may calculate the second voltage deviation dV2 that is a deviation between the second average voltage $V_{T-3}$, which is an average voltage calculated at the time 'T-3', and the third average voltage $V_{T-2}$, which is an average voltage calculated at the time 'T-2', of each of the plurality of battery cells 110, 120, 130, and 140.

In operation S102, the controller 220 may calculate the third voltage deviation dV3 that is a deviation between the third average voltage $V_{T-2}$, which is an average voltage calculated at the time 'T-2', and the fourth average voltage $V_{T-1}$, which is an average voltage calculated at the time 'T-1', of each of the plurality of battery cells 110, 120, 130, and 140.

In operation S102, the controller 220 may calculate the fourth voltage deviation dV4 that is a deviation between the fourth average voltage $V_{T-1}$, which is an average voltage calculated at the time 'T-1', and the fifth average voltage $V_T$, which is an average voltage calculated at the time 'T', of each of the plurality of battery cells 110, 120, 130, and 140.

In operation S102, that is, the controller 220 may calculate a deviation between consecutively calculated average voltages, i.e., a deviation between the first average voltage $V_{T-4}$ and the second average voltage $V_{T-3}$, a deviation between the second average voltage $V_{T-3}$ and the third average voltage $V_{T-2}$, a deviation between the third average voltage $V_{T-2}$ and the fourth average voltage $V_{T-1}$, and a deviation between the fourth average voltage $V_{T-1}$ and the fifth average voltage $V_T$, so as to analyze a short-term voltage behavior of each of the plurality of battery cells 110, 120, 130, and 140.

In operation S102, to analyze a long-term voltage behavior of each of the plurality of battery cells 110, 120, 130, and 140, the controller 220 may calculate a deviation between average voltages that are not calculated consecutively. For example, the controller 220 may calculate a fifth voltage deviation dV5 that is a deviation between the second average voltage $V_{T-3}$, which is the average voltage calculated at the time 'T-3', and the fifth average voltage $V_T$, which is the average voltage calculated at the time 'T', of each of the plurality of battery cells 110, 120, 130, and 140.

In operation S103, the controller 220 may classify a plurality of voltage deviations of each of the plurality of battery cells 110, 120, 130, and 140 based on a calculation point in time. In operation S103, the controller 220 may generate the first average AVG_1 that is an average of voltage deviations of each of the plurality of battery cells 110, 120, 130, and 140 calculated at the same calculation point in time.

In operation S103, for example, the controller 220 may classify the voltage deviations of each of the plurality of battery cells 110, 120, 130, and 140 based on a calculation point in time and calculate the first average AVG_1 of the first voltage deviations dV1 calculated at the same point in time, the first average AVG_1 of the second voltage deviations dV2 calculated at the same point in time, the first average AVG_1 of the third voltage deviations dV3 calculated at the same point in time, the first average AVG_1 of the fourth voltage deviations dV4 calculated at the same point in time, and the first average AVG_1 of the fifth voltage deviations dV5 calculated at the same point in time, of each of the plurality of battery cells 110, 120, 130, and 140.

In operation S104, the controller 220 may calculate the cosine similarity between the plurality of first averages AVG_1 of the plurality of battery cells 110, 120, 130, and 140 and the plurality of voltage deviations of each of the plurality of battery cells 110, 120, 130, and 140. Herein, the cosine similarity may mean a similarity between two vectors, measured using a cosine value of an angle between the vectors.

In operation S104, the controller 220 may calculate the cosine similarity between the plurality of first averages AVG_1 and the plurality of voltage deviations of each of the plurality of battery cells 110, 120, 130, and 140, based on Equation 2.

[Equation 2]

$$\text{Cosine Similarity} = \cos(\theta) = \frac{A \cdot B}{\|A\| \, \|B\|} = \frac{\sum_{i=1}^{n} A_i \times B_i}{\sqrt{\sum_{i=1}^{n}(A_i)^2} \times \sqrt{\sum_{i=1}^{n}(B_i)^2}}$$

In operation S104, the controller 220 may input the plurality of first averages AVG_1 of the plurality of battery cells 110, 120, 130, and 140 to 'A' of Equation 2 and input the plurality of voltage deviations of each of the plurality of battery cells 110, 120, 130, and 140 to 'B' of Equation 2, thus calculating the cosine similarity of each of the plurality of battery cells 110, 120, 130, and 140.

In operation S104, the controller 220 may calculate a cosine similarity of each of the plurality of battery cells 110, 120, 130, and 140 by using Equation 2.

In operation S104, the controller 220 may calculate the second average AVG_2 that is an average of cosine similarities of the plurality of battery cells 110, 120, 130, and 140.

In operation S104, the controller 220 may diagnose at least one of the plurality of battery cells 110, 120, 130, and 140, by using the second average AVG_2 and the cosine similarity of each of the plurality of battery cells 110, 120, 130, and 140.

In operation S104, more specifically, the controller 220 may calculate a first value that is a difference between the second average AVG_2 that is an average of cosine similarities of the plurality of battery cells 110, 120, 130, and 140 and the cosine similarity of each of the plurality of battery cells 110, 120, 130, and 140.

In operation S104, the controller 220 may determine whether the first value of at least one of the plurality of battery cells 110, 120, 130, and 140 is greater than or equal to a threshold.

In operation S104, the controller 220 may continuously calculate a ratio of the first value of each of the plurality of battery cells 110, 120, 130, and 140 to the threshold at specific period. In operation S104, the controller 220 may continuously calculate the rate of the first value of each of the plurality of battery cells 110, 120, 130, and 140 to the threshold at specific period to analyze an abnormal behavior of the voltage of each of the plurality of battery cells 110, 120, 130, and 140 with respect to the total voltage of the plurality of battery cells 110, 120, 130, and 140. In operation S104, the controller 220 may continuously, at specific period, perform an analysis indicating how much the voltage of each of the plurality of battery cells 110, 120, 130, and 140 is different from a voltage of a normal battery cell.

In operation S104, when the first value of at least one of the plurality of battery cells 110, 120, 130, and 140 is greater than or equal to the threshold, the controller 220 may increase a diagnosis count value of the at least one battery cell.

In operation S104, when the diagnosis count value of at least one of the plurality of battery cells 110, 120, 130, and 140 is greater than or equal to the threshold count value, the controller 220 may determine the at least one battery cell as an abnormal battery cell and perform a diagnosis. In operation S104, when the diagnosis count value of at least one of the plurality of battery cells 110, 120, 130, and 140 reaches a threshold count value of 100, the controller 220 may determine the at least one battery cell as an abnormal battery cell and perform a diagnosis.

In operation S104, when the controller 220 determines that the battery cell is abnormal, as a result of the diagnosis, the controller 220 may provide information about the abnormal battery cell to a user. In operation S104, for example, the controller 220 may provide information about an abnormal battery cell to a user terminal through a communication unit (not shown) and provide the information about the abnormal battery cell through a display provided in a vehicle, a charger, etc.

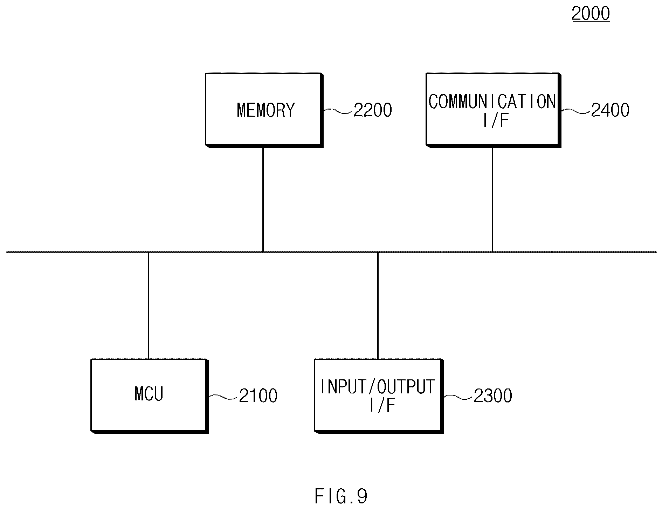

FIG. 9 is a block diagram showing a hardware configuration of a computing system for performing an operating method of a battery management apparatus, according to an embodiment disclosed herein.

Referring to FIG. 9, a computing system 2000 according to an embodiment disclosed herein may include a microcontroller unit (MCU) 2100, a memory 2200, an input/output interface (I/F) 2300, and a communication I/F 2400.

The MCU 2100 may be a processor that executes various programs (e.g., a battery voltage change amount analysis program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM

(SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[DESCRIPTION OF SYMBOLS]

1000: Battery Pack
100: Battery Module
110: First Battery Cell
120: Second Battery Cell

130: Third Battery Cell
140: Fourth Battery Cell
200: Battery Management Apparatus
210: Data Management Unit
220: Controller
230: Memory
300: Relay
2000: Computing System
2100: MCU
2200: Memory
2300: Input/Output I/F
2400: Communication I/F

**Claims**

1. A battery management apparatus comprising:

   a data management unit configured to calculate a plurality of average voltages of each of a plurality of batteries by using a voltage of each of the plurality of batteries, measured for a specific period; and
   a controller configured to calculate a plurality of voltage deviations which are deviations between the plurality of average voltages of each of the plurality of batteries and diagnose at least one battery among the plurality of batteries by using a cosine similarity between an average of the plurality of voltage deviations of each of the plurality of batteries and the plurality of voltage deviations of each of the plurality of batteries.

2. The battery management apparatus of claim 1, further comprising a memory configured to store the voltage of each of the plurality of batteries and an average voltage of each of the plurality of batteries.

3. The battery management apparatus of claim 2, wherein the memory is further configured to store an average voltage of each of the plurality of batteries in a circular queue at specific period.

4. The battery management apparatus of claim 3, wherein the controller is further configured to classify the plurality of voltage deviations of each of the plurality of batteries based on a calculation point in time and generate a first average which is an average of voltage deviations of each of the plurality of batteries, calculated at a same point in time.

5. The battery management apparatus of claim 4, wherein
   the controller is further configured to:

   calculate a cosine similarity of each of the plurality of batteries, which is a cosine similarity between the first average and the plurality of voltage deviations of each of the plurality of batteries; and
   calculate a first value which is a difference between a second average, which is an average of the cosine similarity of each of the plurality of batteries, and the cosine similarity of each of the plurality of batteries.

6. The battery management apparatus of claim 5, wherein the controller is further configured to increase a diagnosis count value of at least one of the plurality of batteries when the first value of the at least one battery is greater than or equal to a threshold.

7. The battery management apparatus of claim 6, wherein the controller is further configured to perform a diagnosis on at least one of the plurality of batteries when the diagnosis count value of the at least one battery is greater than or equal to a threshold count value.

8. An operating method of a battery management apparatus, the operating method comprising:

   calculating a plurality of average voltages of each of a plurality of batteries by using a voltage of each of the plurality of batteries, measured for a specific period;
   calculating a plurality of voltage deviations which are deviations between the plurality of average voltages of each of the plurality of batteries;
   calculating an average of the plurality of voltage deviations of each of the plurality of batteries; and

diagnosing at least one battery among the plurality of batteries by using a cosine similarity between the average of the plurality of voltage deviations of each of the plurality of batteries and the plurality of voltage deviations of each of the plurality of batteries.

9. The operating method of a battery management apparatus of claim 8, wherein the calculating of the plurality of average voltages of each of the plurality of batteries by using the voltage of each of the plurality of batteries, measured for the specific period, comprises storing an average voltage of each of the plurality of batteries in a circular queue at specific period.

10. The operating method of a battery management apparatus of claim 9, wherein the calculating of the average of the plurality of voltage deviations of each of the plurality of batteries comprises classifying the plurality of voltage deviations of each of the plurality of batteries based on a calculation point in time and generating a first average which is an average of voltage deviations of each of the plurality of batteries, calculated at a same point in time.

11. The operating method of a battery management apparatus of claim 10, wherein the diagnosing of the at least one battery among the plurality of batteries by using the cosine similarity between the average of the plurality of voltage deviations of each of the plurality of batteries and the plurality of voltage deviations of each of the plurality of batteries comprises:

calculating a cosine similarity of each of the plurality of batteries, which is a cosine similarity between the first average and the plurality of voltage deviations of each of the plurality of batteries; and
calculating a first value which is a difference between a second average, which is an average of the cosine similarity of each of the plurality of batteries, and the cosine similarity of each of the plurality of batteries.

12. The operating method of a battery management apparatus of claim 11, wherein the diagnosing of the at least one battery among the plurality of batteries by using the cosine similarity between the average of the plurality of voltage deviations of each of the plurality of batteries and the plurality of voltage deviations of each of the plurality of batteries comprises increasing a diagnosis count value of at least one of the plurality of batteries when the first value of the at least one battery is greater than or equal to a threshold.

13. The operating method of a battery management apparatus of claim 12, wherein the diagnosing of the at least one battery among the plurality of batteries by using the cosine similarity between the average of the plurality of voltage deviations of each of the plurality of batteries and the plurality of voltage deviations of each of the plurality of batteries comprises performing a diagnosis on at least one of the plurality of batteries when the diagnosis count value of the at least one battery is greater than or equal to a threshold count value.

1000

300

110

111

112

113

114

BATTERY MANAGEMENT
APPARATUS
200

FIG.1

200

| DATA MANAGEMENT<br>UNIT<br>210 | CONTROLLER<br>220 | MEMORY<br>230 |
|---|---|---|

FIG.2

VOLTAGE(V)

FIG.3

| BATTERY CELL NO. | FIRST AVERAGE VOLTAGE ($V_{T-4}$) | SECOND AVERAGE VOLTAGE ($V_{T-3}$) | THIRD AVERAGE VOLTAGE ($V_{T-2}$) | FOURTH AVERAGE VOLTAGE ($V_{T-1}$) | FIFTH AVERAGE VOLTAGE ($V_T$) |
|---|---|---|---|---|---|
| 1 | 3.687 | 3.657 | 3.651 | 3.647 | 3.607 |
| 2 | 3.687 | 3.657 | 3.651 | 3.647 | 3.607 |
| 3 | 3.687 | 3.657 | 3.651 | 3.647 | 3.607 |
| 4 | 3.687 | 3.657 | 3.651 | 3.647 | 3.607 |
| 5 | 3.687 | 3.707 | 3.651 | 3.647 | 3.607 |
| ... | ... | ... | ... | ... | ... |

FIG.4A

FIG.4B

| BATTERY CELL NO. | FIRST VOLTAGE DEVIATION (dV1) | SECOND VOLTAGE DEVIATION (dV2) | THIRD VOLTAGE DEVIATION (dV3) | FOURTH VOLTAGE DEVIATION (dV4) | FIFTH VOLTAGE DEVIATION (dV5) |
|---|---|---|---|---|---|
| 1 | 0.03 | 0.006 | 0.004 | 0.04 | 0.05 |
| 2 | 0.03 | 0.006 | 0.004 | 0.04 | 0.05 |
| 3 | 0.03 | 0.006 | 0.004 | 0.04 | 0.05 |
| 4 | 0.03 | 0.006 | 0.004 | 0.04 | 0.05 |
| 5 | −0.02 | 0.056 | 0.004 | 0.04 | 0.1 |
| ... | ... | ... | ... | ... | ... |
| FIRST AVERAGE (AVG_1) | 0.04 | 0.0096 | 0.004 | 0.036 | 0.004 |

FIG.5A

VOLTAGE DEVIATION(V)

FIG.5B

| BATTERY CELL NO. | COSINE SIMILARITY |
|---|---|
| 1 | 0.1399970564682822 |
| 2 | 0.1399970564682822 |
| 3 | 0.1399970564682822 |
| 4 | 0.1399970564682822 |
| 5 | 0.024710896694824513 |
| ... | ... |
| SECOND AVERAGE(AVG_2) | 0.11694 |

FIG.6A

COSINE
SIMILARITY

FIG.6B

FIG.7

START

CALCULATE PLURALITY OF AVERAGE VOLTAGES OF EACH OF PLURALITY OF BATTERIES BY USING VOLTAGE OF EACH OF PLURALITY OF BATTERIES, MEASURED FOR SPECIFIC PERIOD ~S101

CALCULATE PLURALITY OF VOLTAGE DEVIATIONS THAT ARE DEVIATIONS BETWEEN PLURALITY OF AVERAGE VOLTAGES OF EACH OF PLURALITY OF BATTERIES ~S102

CALCULATE AVERAGE OF PLURALITY OF VOLTAGE DEVIATIONS OF EACH OF PLURALITY OF BATTERIES ~S103

DIAGNOSE AT LEAST ONE BATTERY AMONG PLURALITY OF BATTERIES BY USING COSINE SIMILARITY BETWEEN AVERAGE OF PLURALITY OF VOLTAGE DEVIATIONS OF EACH OF PLURALITY OF BATTERIES AND PLURALITY OF VOLTAGE DEVIATIONS OF EACH OF PLURALITY OF BATTERIES ~S104

END

FIG.8

2000

MEMORY ~2200

COMMUNICATION I/F ~2400

MCU ~2100

INPUT/OUTPUT I/F ~2300

FIG.9

## INTERNATIONAL SEARCH REPORT

| International application No. |
| --- |
| **PCT/KR2024/002644** |

### A. CLASSIFICATION OF SUBJECT MATTER

**G01R 31/396**(2019.01)i; **G01R 31/385**(2019.01)i; **G01R 19/00**(2006.01)i; **G01R 19/10**(2006.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/396(2019.01); G01R 19/00(2006.01); G01R 31/36(2006.01); G01R 31/367(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 평균 전압(average voltage), 편차(deviation), 진단 (diagnosis), 코사인 유사도(cosine similarity)

### C. DOCUMENTS CONSIDERED TO BE RELEVANT

| Category* | Citation of document, with indication, where appropriate, of the relevant passages | Relevant to claim No. |
| --- | --- | --- |
| A | CN 112014759 A (LIANGDAO (SHENZHEN) ENERGY STORAGE TECHNOLOGY CO., LTD.) 01 December 2020 (2020-12-01)<br>See claim 1 and figures 1-4. | 1-13 |
| A | KR 10-2016-0036422 A (HYUNDAI MOTOR COMPANY) 04 April 2016 (2016-04-04)<br>See paragraphs [0025]-[0028], claims 1-4 and figures 2-3. | 1-13 |
| A | KR 10-1806705 B1 (HYUNDAI MOTOR COMPANY) 07 December 2017 (2017-12-07)<br>See claims 1-5 and figure 2. | 1-13 |
| A | KR 10-2016-0097030 A (SAMSUNG ELECTRONICS CO., LTD.) 17 August 2016 (2016-08-17)<br>See paragraphs [0017]-[0023] and figures 1-5. | 1-13 |
| A | KR 10-2022-0074797 A (LG ENERGY SOLUTION, LTD.) 03 June 2022 (2022-06-03)<br>See claims 1-4 and figures 3-7. | 1-13 |

☐ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
| --- | --- |
| **17 June 2024** | **18 June 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2024/002644**

| Patent document cited in search report | | | Publication date (day/month/year) | Patent family member(s) | | | Publication date (day/month/year) |
|---|---|---|---|---|---|---|---|
| CN | 112014759 | A | 01 December 2020 | CN | 112014759 | B | 14 April 2023 |
| KR | 10-2016-0036422 | A | 04 April 2016 | DE | 102014225645 | A1 | 31 March 2016 |
| | | | | DE | 102014225645 | B4 | 28 November 2019 |
| | | | | KR | 10-1637683 | B1 | 07 July 2016 |
| | | | | US | 10797330 | B2 | 06 October 2020 |
| | | | | US | 2016-0091570 | A1 | 31 March 2016 |
| KR | 10-1806705 | B1 | 07 December 2017 | | None | | |
| KR | 10-2016-0097030 | A | 17 August 2016 | KR | 10-2356475 | B1 | 27 January 2022 |
| | | | | US | 10114078 | B2 | 30 October 2018 |
| | | | | US | 2016-0231388 | A1 | 11 August 2016 |
| KR | 10-2022-0074797 | A | 03 June 2022 | CN | 115461634 | A | 09 December 2022 |
| | | | | EP | 4152021 | A1 | 22 March 2023 |
| | | | | JP | 2023-519949 | A | 15 May 2023 |
| | | | | JP | 7483922 | B2 | 15 May 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230028077